# EUROPEAN PATENT SPECIFICATION

(11) **EP 4 199 674 B1**
(45) Date of publication and mention of the grant of the patent: **11.11.2026**
(21) Application number: 22208313.1
(22) Date of filing: 18.11.2022
(51) Int. Cl.: H05K 7/20

(54) **COOLING APPARATUS FOR POWER MODULE**
KÜHLVORRICHTUNG FÜR LEISTUNGSMODUL
APPAREIL DE REFROIDISSEMENT POUR MODULE DE PUISSANCE

(30) Priority: 20.12.2021 KR 20210183141
(43) Date of publication of application: 21.06.2023
(60) Divisional application: 26208161.5
(73) Proprietor: Hyundai Motor Company, Seoul 06797 (KR); Kia Corporation, Seocho-gu Seoul 06797 (KR); Chung Ang University Industry Academic Cooperation Foundation, Seoul 06974 (KR)
(72) Inventor: LEE, Sang Hun, 18280 Gyeonggi-do (KR); KWON, Se Heun, 18280 Gyeonggi-do (KR); LEE, Seong Min, 18280 Gyeonggi-do (KR); LEE, Je Hwan, 18280 Gyeonggi-do (KR); PARK, Hyong Joon, 18280 Gyeonggi-do (KR); KIM, Yun Seo, 06974 Seoul (KR); LEE, Geon Hee, 06974 Seoul (KR); KONG, Dae Young, 06974 Seoul (KR); KANG, Min Soo, 06974 Seoul (KR); LEE, Hyoung Soon, 06974 Seoul (KR)
(74) Representative: Hoffmann Eitle

(56) References cited:
- EP-A1- 4 203 637
- US-A1- 2014 252 585
- US-A1- 2017 055 378
- US-A1- 2019 181 717
- US-A1- 2020 344 920

## Description

### TECHNICAL FIELD

The present disclosure relates to a cooling apparatus for a power module cooling the power module by using a cooling fluid.

### BACKGROUND

A power module is applied to an electric vehicle, etc. to control a high voltage and a large current. Therefore, the amount of heat generated is very large and therefore, proper cooling is required to maintain performance and durability. To this end, the power module is cooled through a cooling fluid, or the waste heat of the power module is used to heat a vehicle.

In the conventional case, it is common to connect a cooling apparatus to one side surface of the power module in order to cool this power module and to distribute the cooling fluid to the cooling apparatus. However, there is a problem in that cooling efficiency is not high by applying a simple tube structure or pin structure generally used to the conventional cooling apparatus.

Since the cooling efficiency of the electric vehicle, etc. is closely related to the overall energy efficiency of the vehicle and greatly affects the durability or performance maintenance of the power module as well, it is necessary to increase the cooling efficiency of the power module through a new cooling structure.

The aforementioned background art is technical information possessed by the inventor to derive the exemplary embodiments of the present disclosure or acquired in the derivation process, and is only for enhancing the understanding of the background of the present disclosure. Therefore, the background art should not be taken as being admitted to corresponding to the known art published to the general public prior to the filing of the exemplary embodiments of the present disclosure or the related art already known to those skilled in the art.

US 2017/055378 A1 relates to jet impingement assemblies and, more particularly, to configurable, double-sided modular jet impingement assemblies.

US 2014/252585 A1 relates to packages for semiconductor devices, packaged semiconductor devices, and methods of cooling packaged semiconductor devices.

US 2020/344920 A1 relates to a cooling apparatus for a power module comprising a plurality of cooling modules to contact each of both surfaces of the power module,
wherein the plurality of cooling modules include a first cooling module and a second cooling module, and at least the first and second cooling modules comprise a manifold cover and a pin plate having one surface to contact the power module, the pin plate having a plurality of pins extending in a second direction crossing the first direction and disposed on the other surface of the pin plate,
wherein a plurality of power modules are to be arranged to be spaced apart from each other and between the plurality of cooling modules, so that the plurality of power modules share the plurality of cooling modules,
wherein the first cooling module is to contact one surface of the power module and comprises an inlet through which the cooling fluid is to be introduced through a supply flow path and the second cooling module is to contact the other surface of the power module and comprises an outlet through which the cooling fluid is to flow out through a discharge flow path,
wherein the pin plate of the first cooling module is to contact one side surface of the power module, the pin plate of the second cooling module is to contact with the other side surface of the power module, and ends of the pin plates of the first cooling module and the second cooling module facing each other are connected to each other through a connection part to distribute the cooling fluid.

### SUMMARY OF THE DISCLOSURE

An object of the present disclosure is to provide a cooling apparatus for a power module, which vertically sprays a cooling fluid on a heat-generated surface through a micropin of a pin plate configured in a direction perpendicular to a direction of a manifold cover and cools the heat-generated surface to cause the vertical turbulent flow of the cooling fluid.

The present invention is defined by the cooling apparatus according to independent claim 1. Optional preferred features are recited in the dependent claims.

The present disclosure provides a cooling apparatus for a power module including a plurality of cooling modules to contact each of both surfaces of the power module, in which the plurality of cooling modules include a first cooling module and a second cooling module, and at least one of the first and second cooling modules includes: a manifold cover including: a plurality of guide walls extending in a first direction in a state of being spaced apart from each other, and a plurality of cooling channels through the plurality of guide walls, the plurality of cooling channels having a first channel and a second channel, a first end of the first channel is blocked and a second end of the second channel is blocked, the second end of the second channel is opposite the first end of the first channel; and a pin plate having one surface to contact the power module, the pin plate having a plurality of pins extending in a second direction crossing the first direction and disposed on the other surface of the pin plate, and the pin plate is coupled to the manifold cover so that at least one of the plurality of pins faces at least one of the plurality of guide walls, so that cooling fluid to be introduced into the first channel flows in the second direction and then flows out through the second channel.

A crossing angle between the first direction and the second direction may be 80 degrees to 100 degrees.

The first direction and the second direction may vertically cross each other.

The inlet may be disposed in the manifold cover of the first cooling module, and the outlet may be disposed in the manifold cover of the second cooling module.

The pin plates of the first cooling module and the second cooling module facing each other may be spaced apart from each other by a thickness of the power module, and the connection part may be disposed at a point between the spaced pin plates.

At least one pin among the plurality of pins of the pin plate may protrude from the pin plate, and the at least one pin may have a shape in which a horizontal cross-sectional area is reduced toward the protruding end.

The at least one pin may have a shape in which a vertical cross-sectional shape of the protruding end is a triangle or a curve.

The manifold cover may further include a rim welding, adhered, or bolted to the pin plate.

According to the cooling apparatus for the power module according to the present disclosure, it is possible to vertically spray the cooling fluid on the heat-generated surface through the micropin of the pin plate configured in the direction perpendicular to the direction of the manifold cover and to cool the heat-generated surface to cause the vertical turbulent flow of the cooling fluid, thereby increasing the heat-dissipation performance of the cooling apparatus even without the separate nozzle spray apparatus.

The first channel of an one side channel group may have the first blocking part connected to the second blocking part of the second channel of the other side channel group adjacent thereto, and the second channel of the one side channel group may have the outlet side connected to an inlet side of the first channel of the other side channel group adjacent thereto.

According to the cooling apparatus for the power module according to the present disclosure, it is possible to vertically spray the cooling fluid on the heat-generated surface through the micropin of the pin plate configured in the direction perpendicular to the direction of the manifold cover and to cool the heat-generated surface to cause the vertical turbulent flow of the cooling fluid, thereby increasing the heat-dissipation performance of the cooling apparatus even without the separate nozzle spray apparatus.

The effect of the present disclosure is not limited to the aforementioned technical effects, and other technical effects may also be derived from the following description.

### BRIEF DESCRIPTION OF THE DRAWINGS

The above and other objects, features and other advantages of the present disclosure will be larger clearly understood from the following detailed description when taken in conjunction with the accompanying drawings, in which:
FIG. 1 is a perspective diagram of a cooling apparatus for a power module according to an exemplary embodiment of the present disclosure.
FIG. 2 is an exploded perspective diagram of the cooling apparatus for the power module shown in FIG. 1.
FIG. 3 is a diagram showing a channel of the cooling apparatus for the power module shown in FIG. 1.
FIG. 4 is a diagram showing a mechanism of the cooling apparatus for the power module shown in FIG. 1.
FIG. 5 is a diagram showing a microchannel of the cooling apparatus for the power module shown in FIG. 1.
FIG. 6 is a diagram showing a thermal analysis simulation result of the cooling apparatus for the power module shown in FIG. 1.
FIG. 7 is a diagram showing a gasket formed on a pin plate of the cooling apparatus for the power module shown in FIG. 1.
FIG. 8 is a diagram showing a pin of a cooling apparatus for a power module according to various exemplary embodiments of the present disclosure.

### DETAILED DESCRIPTION OF THE DISCLOSURE

Specific structural or functional descriptions of the exemplary embodiments of the present disclosure disclosed in the present specification or application are only exemplified for the purpose of describing the exemplary embodiments according to the present disclosure, and the exemplary embodiments according to the present disclosure may be embodied in various forms and should not be interpreted as being limited to the exemplary embodiments described in the present specification or application. Hereinafter, exemplary embodiments of the present disclosure will be described in detail with reference to the accompanying drawings.

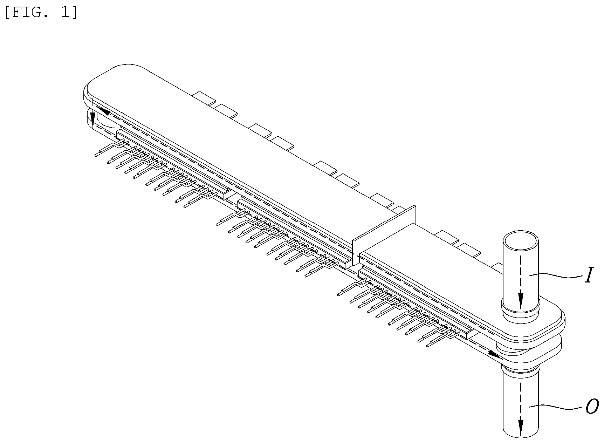

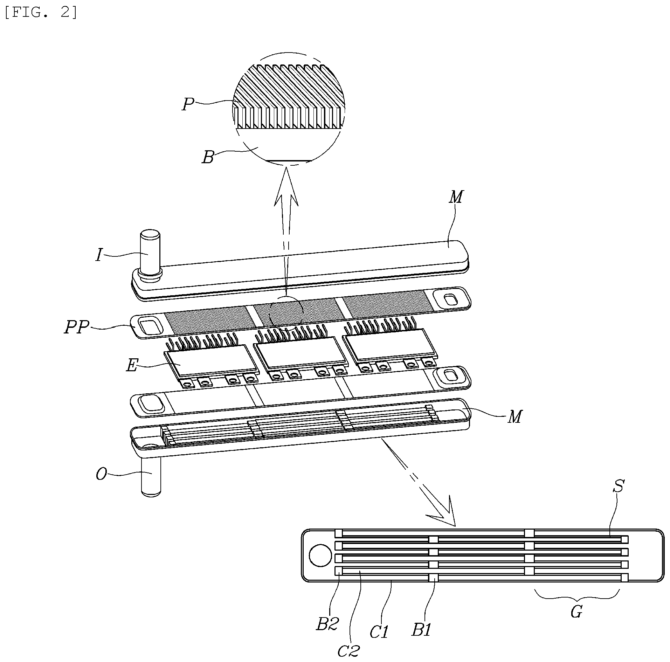

FIG. 1 is a perspective diagram of a cooling apparatus for a power module according to an exemplary embodiment of the present disclosure, and FIG. 2 is an exploded perspective diagram of the cooling apparatus for the power module shown in FIG. 1. Therefore, a cooling apparatus for a power module according to an exemplary embodiment of the present disclosure includes a power module E and a plurality of cooling modules provided to be in contact with each of both surfaces of the power module in order to cool the power module. Each cooling module is provided with a manifold cover M provided with a plurality of guide walls S extending in a first direction to partition a cooling channel into a plurality of cooling channels so that a cooling fluid flows from an inlet to an outlet in the first direction. In addition, the plurality of cooling channels partitioned by the guide wall S are composed of a first channel C1 whose outlet side is blocked and a second channel C2 whose inlet side is blocked.

In addition, the cooling module according to the present disclosure is provided with a pin plate PP. The pin plate PP has one surface being in contact with the power module E and has a plurality of pins (P) extending in a second direction formed on the other surface thereof so that the cooling fluid introduced from the inlet to the first channel C1 flows in the second direction crossing the first direction and then flows to the outlet through the second channel C2. In other words, the cooling fluid is designed to be partitioned into a plurality of cooling fluids, guided in the first direction, and then blocked to flow in the second direction in which the pin P extends to form an impingement jet cooling structure, thereby increasing the efficiency of heat exchange.

First, as shown in FIG. 1, the cooling apparatus for the power module according to an exemplary embodiment of the present disclosure is designed based on double-sided cooling that simultaneously cools all of both surfaces of the power module E. Therefore, as shown in FIGS. 1 and 2, the cooling apparatus for the power module may be configured in a series-type structure in which the cooling fluid introduced from an inlet I flows and flows out to an outlet O. Although FIG. 1 shows a direction in which the cooling fluid flows from the top to the bottom, the flow direction may also be opposite thereto and is not limited to only the vertical direction.

As shown in FIG. 2, the pin plate PP has one surface of a plate B being in contact with the power module E and has the plurality of pins P formed on the other surface thereof. The manifold cover M includes the first channel C1 whose outlet side is blocked and the second channel C2 whose inlet side is blocked. The power module E is cooled by forming the cooling module including the manifold cover M and the pin plate PP to be in contact with each of both surfaces of the power module E.

In the cooling apparatus for the power module according to the exemplary embodiment of the present disclosure, the first channel C1 includes a first blocking part B1 formed to protrude from the end from which the guide wall extends in order to block the outlet side thereof in the manifold cover M, and the second channel C2 includes a second blocking part B2 formed to protrude from the end from which the guide wall extends in order to block the inlet side thereof in the manifold cover M.

In other words, the first blocking part B1 and the second blocking part B2 are configured so that the cooling fluid introduced from the inlet flows and the outlet side of the first channel C1 is blocked, or the inlet side of the second channel C2 is blocked and the cooling fluid flows to the outlet side of the second channel C2, respectively. FIG. 2 shows each of the first blocking part B1 and the second blocking part B2 in a protruding form, but the present disclosure is not limited thereto. In addition, as shown in FIG. 2, the cooling apparatus for the power module according to the exemplary embodiment of the present disclosure is provided to be in contact with each of both surfaces of the power module E, thereby increasing cooling performance.

Specifically, the pin plate PP shown in FIG. 2 includes the pins P alternately formed at a separated interval to extend in the second direction. In other words, the pin P shown in FIG. 1 has the form of a fin pin configured like a fin. FIG. 2 shows that the pin P is formed in a direction perpendicular to the plate B, but the present disclosure is not limited thereto.

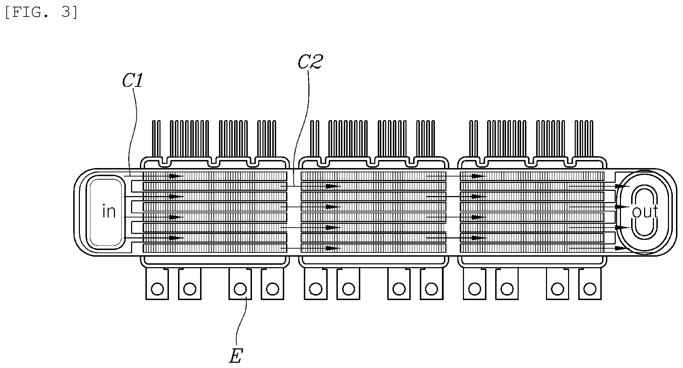

Meanwhile, as shown in FIG. 3, a cooling apparatus for a power module according to another exemplary embodiment of the present disclosure includes: a plurality of power modules E and a plurality of cooling modules provided to be in contact with each of both surfaces of the power module E in order to cool each power module E, in which the cooling module and the other cooling modules adjacent thereto are connected in series with each other.

Therefore, the cooling fluid flowing to the outlet through the second channel C2 flows into the first channels C1 of the manifold covers M of the other neighboring cooling modules connected in series. In other words, the cooling module cools the other neighboring power modules. In addition, the cooling apparatus for the power module according to another exemplary embodiment of the present disclosure allows the cooling fluid to cool the power module at a greater mass flow rate than in the method for cooling each power module in parallel.

Specifically, the plurality of power modules E are arranged to be spaced apart from each other between a pair of cooling modules, so that the plurality of power modules E shares the cooling module, and the cooling module is formed with a plurality of channel group G to correspond to each power module E.

Each channel group G is provided with the first channel C1 and the second channel C2, in which the first channel (C1) is formed with the first blocking part B1 connecting one ends of the guide walls of both sides partitioning the first channel C1 in order to block the outlet side thereof, and the second channel C2 is formed with the second blocking part B2 connecting the other ends of the guide walls of both sides partitioning the second channel C2 to block the inlet side thereof.

The first blocking part of the first channel of an one side channel group is connected to the second blocking part of the second channel of the other side channel group adjacent thereto, and the second channel of the one side channel group has the outlet side connected to the inlet side of the first channel of the other side channel group adjacent thereto, so that the cooling fluid repeatedly moves in the order of the first channel-the second channel-the first channel and implements the impingement jet cooling.

In addition, as shown in FIG. 3, the second direction in which the pin P extends may be perpendicular to the direction in which the guide wall S extends. In other words, the first channel included in the manifold cover M allows the cooling fluid to go through the vertical pin while flowing in the direction in which the guide wall S extends so that the effect of the impingement jet cooling may be implemented.

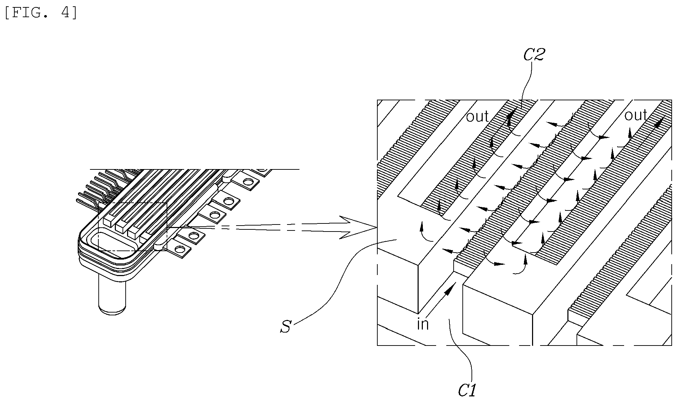

FIG. 4 is a diagram showing a mechanism of the cooling apparatus for the power module according to the exemplary embodiment of the present disclosure. As shown in FIG. 4, the guide wall S guides the cooling fluid to the inlet and the outlet to flow in the first direction. Since the cooling fluid flows in the first direction while overflowing the pin P having one surface being in contact with the power module E in the process of flowing in the first direction, the primary jet cooling is performed in this process. Next, the first channel C1 through which the cooling fluid flows in the first direction is configured to block the outlet side thereof. The blocked and overflowing cooling fluid overflows the plurality of pins P extending in the second direction crossing the first direction and flows into the second channel C2 through the top or bottom of the guide wall S. Therefore, in the cooling apparatus for the power module according to the exemplary embodiment of the present disclosure, turbulence, which is a velocity component in a direction perpendicular to the flow direction, occurs in the process in which the cooling fluid flows into the second channel C2. Thereafter, the second channel C2 is configured to block the inlet side, so that the cooling fluid flowing into the second channel C2 flows only to the outlet side.

The exemplary embodiment of the present disclosure provides an apparatus that uses the cooling fluid in order to cool the power module. In order to cool this power module, the exemplary embodiment of the present disclosure intends to apply the effect of the impingement jet cooling. Here, the impingement jet cooling means a cooling method capable of locally obtaining the high heat transfer effect as the method for directly spraying cooling air on a high-temperature wall to remove the heat. In order to actively implement the effect of the jet cooling method, it is necessary to use turbulent flow other than laminar flow. Here, the turbulence means a flow having a velocity component in the direction perpendicular to the flow direction, that is, a flow having irregularity and diffusivity due to vertical and horizontal 3D vorticity other than the flow direction. When the turbulence occurs around the object, the cooling area and the mixing of the cooling fluid may become larger, thereby increasing the cooling efficiency.

The cooling apparatus for the power module according to the exemplary embodiment of the present disclosure crosses the second direction in which the pin P of the pin plate extends with the first direction in which the cooling fluid flows to the guide wall of the manifold cover M in order to cause the turbulent flow to further increase the effect of this impingement jet cooling. This causes the turbulence beyond simply passing the pin plate as the laminar flow like the pock on a golf ball or the bumpy skin of a shark. Therefore, it is possible to improve the cooling performance of the cooling apparatus of the power module according to the exemplary embodiment of the present disclosure.

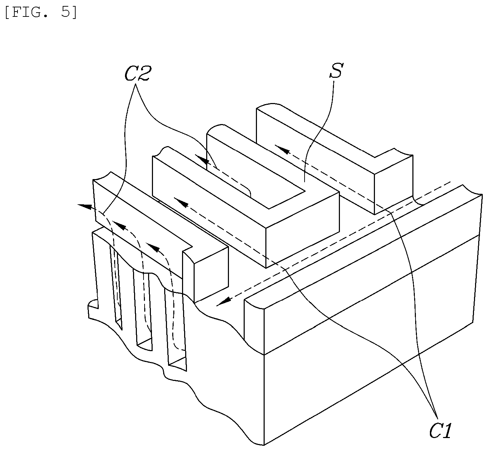

FIG. 5 is a diagram showing a microchannel of the cooling apparatus for the power module according to the exemplary embodiment of the present disclosure. As shown in FIG. 5, the cooling fluid is introduced from the inlet to form an inlet plenum that is the sum of narrow streams of water. The manifold cover M allows the cooling fluid guided based on the guide wall S to flow into the first channel C1 or the second channel C2 to be discharged through the plurality of pins P to form a microchannel. As the second direction in which the pin P extends and the first direction of the guide wall S of the manifold cover M cross each other, the turbulence occurs in the process in which the cooling fluid flowing into the first channel C1 is blocked at the outlet side and flows into the second channel C2 through the pin because the outlet side of the first channel C1 is blocked. The cooling fluid that is the turbulence passes through the pin P while flowing to the outlet side of the second channel C2, which is each manifold channel, because the inlet side thereof is blocked. Therefore, the cooling fluid of the second channel C2 with increased vorticity, irregularity, and diffusivity forms the effect of the higher impingement jet cooling.

Unlike shown in FIG. 5, in the cooling apparatus for the power module according to the exemplary embodiment of the present disclosure, a crossing angle at which the second direction and the first direction in which the pin P extends cross each other may be 80 degrees to 100 degrees. In other words, an angle between the direction in which the pin extends and the flow direction of the cooling fluid of the manifold cover is not necessarily 90 degrees, and another exemplary embodiment such as slightly tilting the direction of the pin may also be implemented.

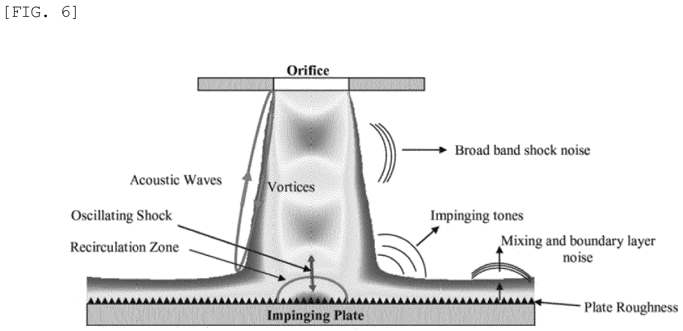

FIG. 6 is a diagram showing a thermal analysis simulation result of the cooling apparatus for the power module according to the exemplary embodiment of the present disclosure. The cooling fluid flowing from the first channel C1 to the second channel C2 forms vortices around a recirculation zone to cause various shock waves such as oscillating shock, mixing and boundary layer noise, and broad band shock noise. Therefore, even a cooling fluid layer, which could not be cooled in the conventional impingement jet cooling of the laminar flow, is recirculated and involved in the cooling, thereby improving the cooling efficiency.

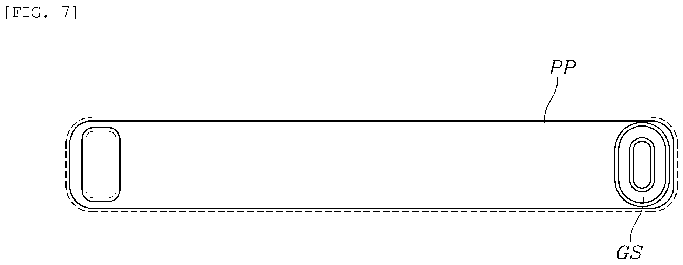

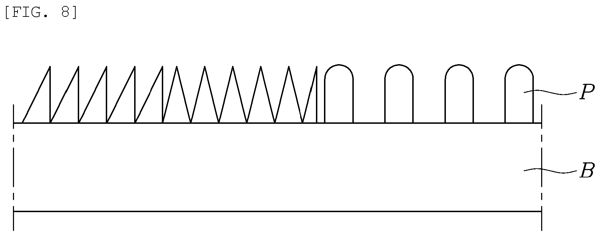

FIG. 7 is a diagram showing a gasket to which the manifold cover and the pin plate of the cooling apparatus for the power module according to the exemplary embodiment of the present disclosure are coupled, and FIG. 8 is a diagram showing the pin of the cooling apparatus for the power module according to the exemplary embodiment of the present disclosure.

Specifically, FIG. 7 is a diagram showing a gasket GS coupled to the pin plate PP of the cooling apparatus for the power module according to the exemplary embodiment of the present disclosure, and the pin plate PP may include a first pin plate coupled to a first surface of the power module E and a second pin plate coupled to a second surface opposite to the first surface of the power module E.

The pin plate of a first cooling module is in contact with one side surface of the power module, the pin plate of a second cooling module is in contact with the other side surface of the power module, and the ends of the pin plates of the first and second cooling modules facing each other may be connected to each other through a connection part GS to distribute the cooling fluid. In addition, the facing pin plates of the first cooling module and the second cooling module may be spaced apart from each other by the thickness of the power module, and the connection part GS may be provided at a point between the separated pin plates.

In other words, the pin plate PP is designed to be in close contact with the power module E to cool both surfaces of the upper and lower surfaces of the power module E. Therefore, as shown in FIG. 7, the pin plate PP may include the gasket GS having a concave or protruding shape as the connection part GS.

In addition, as a region shown by the dotted line in FIG. 7, the manifold cover M of the cooling apparatus for the power module according to the exemplary embodiment of the present disclosure may be coupled to the pin plate PP in any one method among weld joint, adhesive bonding, and bolted joint.

FIG. 8 is a diagram showing the pin of the cooling apparatus for the power module according to the exemplary embodiment of the present disclosure, and in the cooling apparatus for the power module according to the exemplary embodiment of the present disclosure, a partial or entire shape of the portion where the pin P is formed may be formed so that the size of a first cross section of the pin perpendicular to the direction in which the pin P extends is reduced in the protruding direction. In addition, in the cooling apparatus for the power module according to the exemplary embodiment of the present disclosure, for the shape of a portion or the entire portion where the pin P is formed, a shape of a second cross section of the pin parallel to the direction in which the pin extends may be formed in any one of a right-angled triangle, an isosceles triangle, and a semicircle.

As in the exemplary embodiment shown in FIG. 8, the pins P may also be alternately formed to be spaced apart from each other at a predetermined interval, and may be repeatedly formed without the predetermined interval. As in another exemplary embodiment shown in FIG. 8, the pin P may have a reduced cross-sectional area of the partial region or the entire region in the direction in which the pin extends, and the pin may be a right-angled triangular, isosceles triangular, or semicircular protrusion structure. Of course, as shown in FIG. 4, the pin may be a rectangular protrusion structure, but is not limited thereto.

The cooling apparatus for the power module according to the exemplary embodiment of the present disclosure uses the impingement jet cooling. The impingement jet cooling may locally obtain the high heat transfer effect by the method for spraying refrigerant on the local heat-generated surface at high speed to remove the heat. Therefore, it is possible to increase the operation lifespan of the power module. In addition, the cooling apparatus for the power module according to the exemplary embodiment of the present disclosure effectively implements the impingement jet cooling only by coupling the pin plate to the manifold cover without having to complexly design the channel (flow path) through which the sprayed refrigerant passes in one direction. Therefore, according to the cooling apparatus for the power module according to the exemplary embodiment of the present disclosure, it is possible to simplify the manufacturing process, and to reduce the number of components, thereby reducing the manufacturing cost.

## Claims

1. A cooling apparatus for a plurality of power modules (E) comprising a plurality of cooling modules to contact each of both surfaces of the power modules),
wherein the plurality of cooling modules include a first cooling module and a second cooling module, and at least the first and second cooling modules comprise
a manifold cover (M) including:
a plurality of guide walls (S) extending in a first direction in a state of being spaced apart from each other, and
a plurality of cooling channels through the plurality of guide walls (S), the plurality of cooling channels having a first channel (C1) and a second channel (C2), a first end of the first channel (C1) is blocked and a second end of the second channel (C2) is blocked, the second end of the second channel (C2) being opposite the first end of the first channel (C1); and
a pin plate (PP) having one surface to contact the power modules (E), the pin plate (PP) having a plurality of pins (P) extending in a second direction crossing the first direction and disposed on the other surface of the pin plate (PP), and the pin plate (PP) is coupled to the manifold cover (M) so that at least one of the plurality of pins (P) faces at least one of the plurality of guide walls (S), so that a cooling fluid to be introduced into the first channel (C1) flows in the second direction and then flows out through the second channel (C2),
wherein the plurality of power modules (E) are to be arranged to be spaced apart from each other and between the plurality of cooling modules, so that the plurality of power modules (E) can share the plurality of cooling modules, and the plurality of cooling modules further includes a plurality of channel groups to correspond to each of the power modules (E),
wherein the first channel (C1) and the second channel (C2) are present in each of the plurality of channel groups, the first channel (C1) includes a first blocking part (B1) connecting first ends of first guide walls on both sides of the first channel (C1) to block an outlet side thereof, and the second channel (C2) includes a second blocking part (B2) connecting second ends of second guide walls on both sides of the second channel (C2) to block an inlet side thereof, and the second ends of the second guide walls are opposite the first ends of the first guide walls,
wherein the first cooling module is to contact one surface of the power modules (E) and comprises an inlet through which the cooling fluid is to be introduced through a supply flow path and the second cooling module is to contact the other surface of the power modules (E) and comprises an outlet through which the cooling fluid is to flow out through a discharge flow path,
wherein the pin plate (PP) of the first cooling module is to contact one side surface of the power modules (E), the pin plate (PP) of the second cooling module is to contact with the other side surface of the power modules (E), and ends of the pin plates (PP) of the first cooling module and the second cooling module facing each other are connected to each other through a connection part to distribute the cooling fluid, and
wherein the first channel (C1) of a one side channel group has the first blocking part (B1) connected to the second blocking part (B2) of the second channel (C2) of the other side channel group adjacent to the one side channel group, and the second channel (C2) of the one side channel group has the outlet side connected to an inlet side of the first channel (C1) of the other side channel group adjacent to the one side channel group.

2. The cooling apparatus of claim 1,
wherein a crossing angle between the first direction and the second direction is 80 degrees to 100 degrees.

3. The cooling apparatus of claim 1,
wherein the first direction and the second direction vertically cross each other.

4. The cooling apparatus of claim 1,
wherein the inlet is disposed in the manifold cover (M) of the first cooling module, and the outlet is disposed in the manifold cover (M) of the second cooling module.

5. The cooling apparatus of claim 1,
wherein the pin plates (PP) of the first cooling module and the second cooling module facing each other are spaced apart from each other, and the connection part is disposed at a point between the spaced pin plates (PP).

6. The cooling apparatus of claim 1,
wherein at least one pin among the plurality of pins (P) of the pin plate (PP) protrudes from the pin plate (PP), and the at least one pin has a shape in which a horizontal cross-sectional area is reduced toward the protruding end.

7. The cooling apparatus of claim 6,
wherein the at least one pin has a shape in which a vertical cross-sectional shape of the protruding end is a triangle or a curve.

8. The cooling apparatus of claim 1,
wherein the manifold cover (M) further includes a rim welded, adhered, or bolted to the pin plate (PP).

## Patentansprüche

1. Kühlvorrichtung für eine Vielzahl von Leistungsmodulen (E), umfassend eine Vielzahl von Kühlmodulen, um in Kontakt zu stehen mit jeder der beiden Oberflächen der Leistungsmodule),
wobei die Vielzahl von Kühlmodulen ein erstes Kühlmodul und ein zweites Kühlmodul einschließt, und zumindest das erste und zweite Kühlmodul Folgendes umfassen
eine Verteilerabdeckung (M), einschließlich:
einer Vielzahl von Leitwänden (S), die sich in einer ersten Richtung in einem Zustand erstrecken, in dem sie voneinander beabstandet sind, und
einer Vielzahl von Kühlkanälen durch die Vielzahl von Leitwänden (S), wobei die Vielzahl von Kühlkanälen einen ersten Kanal (C1) und einen zweiten Kanal (C2) aufweist, ein erstes Ende des ersten Kanals (C1) verschlossen ist und ein zweites Ende des zweiten Kanals (C2) verschlossen ist, wobei das zweite Ende des zweiten Kanals (C2) dem ersten Ende des ersten Kanals (C1) gegenüberliegt; und
eine Stiftplatte (PP), die eine Oberfläche aufweist, um mit den Leistungsmodulen (E) in Kontakt zu stehen, wobei die Stiftplatte (PP) eine Vielzahl von Stiften (P) aufweist, die sich in einer die erste Richtung kreuzenden zweiten Richtung erstrecken und auf der anderen Oberfläche der Stiftplatte (PP) angeordnet sind, und die Stiftplatte (PP) mit der Verteilerabdeckung (M) gekoppelt ist, sodass zumindest einer der Vielzahl von Stiften (P) zumindest einer der Vielzahl von Leitwänden (S) gegenüberliegt, sodass ein in den ersten Kanal (C1) zuzuführendes Kühlfluid in der zweiten Richtung strömt und dann durch den zweiten Kanal (C2) ausströmt,
wobei die Vielzahl von Leistungsmodulen (E) voneinander beabstandet und zwischen der Vielzahl von Kühlmodulen anzuordnen sind, sodass die Vielzahl von Leistungsmodulen (E) die Vielzahl von Kühlmodulen mitnutzen kann, und die Vielzahl von Kühlmodulen weiter eine Vielzahl von Kanalgruppen einschließt, die jeweils einem der Leistungsmodule entsprechen,
wobei der erste Kanal (C1) und der zweite Kanal (C2) in jeder der Vielzahl von Kanalgruppen vorhanden sind, wobei der erste Kanal (C1) einen ersten Sperrabschnitt (B1) einschließt, der erste Enden erster Leitwände auf beiden Seiten des ersten Kanals (C1) verbindet, um eine Auslassseite davon zu verschließen, und der zweite Kanal (C2) einen zweiten Sperrabschnitt (B2) einschließt, der zweite Enden zweiter Leitwände auf beiden Seiten des zweiten Kanals (C2) verbindet, um eine Einlassseite davon zu verschließen, und die zweiten Enden der zweiten Leitwände den ersten Enden der ersten Leitwände gegenüberliegen,
wobei das erste Kühlmodul mit einer Oberfläche der Leistungsmodule (E) in Kontakt stehend ist und einen Einlass umfasst, durch den das Kühlfluid durch einen Zufuhrströmungsweg zugeführt wird, und das zweite Kühlmodul mit der anderen Oberfläche der Leistungsmodule (E) in Kontakt stehend ist und einen Auslass umfasst, durch den das Kühlfluid durch einen Ablassströmungsweg ausströmt,
wobei die Stiftplatte (PP) des ersten Kühlmoduls mit einer Seitenfläche der Leistungsmodule (E) in Kontakt stehend ist, die Stiftplatte (PP) des zweiten Kühlmoduls mit der anderen Seitenfläche der Leistungsmodule (E) in Kontakt stehend ist, und Enden der Stiftplatten (PP) des ersten Kühlmoduls und des zweiten Kühlmoduls, die einander gegenüberliegen, durch ein Verbindungsteil miteinander verbunden sind, um das Kühlfluid zu verteilen, und
wobei der erste Kanal (C1) einer Kanalgruppe auf der einen Seite den ersten Sperrabschnitt (B1) aufweist, der mit dem zweiten Sperrabschnitt (B2) des zweiten Kanals (C2) der Kanalgruppe auf der anderen Seite, die der Kanalgruppe auf der einen Seite benachbart ist, verbunden ist, und der zweite Kanal (C2) der Kanalgruppe auf der einen Seite die Auslassseite aufweist, die mit einer Einlassseite des ersten Kanals (C1) der Kanalgruppe auf der anderen Seite, die der Kanalgruppe auf der einen Seite benachbart ist, verbunden ist.

2. Kühlvorrichtung nach Anspruch 1,
wobei ein Kreuzungswinkel zwischen der ersten Richtung und der zweiten Richtung 80 Grad bis 100 Grad beträgt.

3. Kühlvorrichtung nach Anspruch 1,
wobei die erste Richtung und die zweite Richtung sich senkrecht kreuzen.

4. Kühlvorrichtung nach Anspruch 1,
wobei der Einlass in der Verteilerabdeckung (M) des ersten Kühlmoduls angeordnet ist und der Auslass in der Verteilerabdeckung (M) des zweiten Kühlmoduls angeordnet ist.

5. Kühlvorrichtung nach Anspruch 1,
wobei die einander gegenüberliegenden Stiftplatten (PP) des ersten Kühlmoduls und des zweiten Kühlmoduls voneinander beabstandet sind und das Verbindungsteil an einem Punkt zwischen den beabstandeten Stiftplatten (PP) angeordnet ist.

6. Kühlvorrichtung nach Anspruch 1,
wobei zumindest ein Stift unter der Vielzahl von Stiften (P) der Stiftplatte (PP) von der Stiftplatte (PP) vorsteht und der zumindest eine Stift eine Form aufweist, bei der eine horizontale Querschnittsfläche zu dem vorstehenden Ende hin verringert ist.

7. Kühlvorrichtung nach Anspruch 6,
wobei der zumindest eine Stift eine Form aufweist, bei der eine vertikale Querschnittsform des vorstehenden Endes ein Dreieck oder eine Kurve ist.

8. Kühlvorrichtung nach Anspruch 1,
wobei die Verteilerabdeckung (M) weiter einen Rand einschließt, der an die Stiftplatte (PP) geschweißt, geklebt oder geschraubt ist.

## Revendications

1. Appareil de refroidissement pour une pluralité de modules de puissance (E) comprenant une pluralité de modules de refroidissement destinés à entrer en contact avec chacune des deux surfaces des modules de puissance),
dans lequel la pluralité de modules de refroidissement incluent un premier module de refroidissement et un second module de refroidissement, et au moins les premier et second modules de refroidissement comprennent un couvercle de collecteur (M) incluant :
une pluralité de parois de guidage (S) s'étendant dans une première direction dans un état dans lequel elles sont espacées les unes des autres, et
une pluralité de canaux de refroidissement à travers la pluralité de parois de guidage (S), la pluralité de canaux de refroidissement ayant un premier canal (C1) et un second canal (C2), une première extrémité du premier canal (C1) étant obturée et une seconde extrémité du second canal (C2) étant obturée, la seconde extrémité du second canal (C2) étant opposée à la première extrémité du premier canal (C1) ; et
une plaque à plots (PP) ayant une surface destinée à entrer en contact avec les modules de puissance (E), la plaque à plots (PP) ayant une pluralité de plots (P) s'étendant dans une seconde direction croisant la première direction et disposés sur l'autre surface de la plaque à plots (PP), et la plaque à plots (PP) est couplée au couvercle de collecteur (M) de sorte qu'au moins un de la pluralité de plots (P) fait face à au moins une de la pluralité de parois de guidage (S), de sorte qu'un fluide de refroidissement devant être introduit dans le premier canal (C1) s'écoule dans la seconde direction puis s'écoule vers l'extérieur à travers le second canal (C2),
dans lequel la pluralité de modules de puissance (E) sont destinés à être disposés entre la pluralité de modules de refroidissement et espacés les uns des autres, de sorte que la pluralité de modules de puissance (E) peut partager la pluralité de modules de refroidissement, et la pluralité de modules de refroidissement inclut en outre une pluralité de groupes de canaux pour correspondre à chacun des modules de puissance (E),
dans lequel le premier canal (C1) et le second canal (C2) sont présents dans chacun de la pluralité des groupes de canaux, le premier canal (C1) inclut une première partie d'obturation (B1) reliant des premières extrémités de premières parois de guidage sur les deux côtés du premier canal (C1) pour obturer un côté de sortie de celui-ci, et le second canal (C2) inclut une seconde partie d'obturation (B2) reliant des secondes extrémités de secondes parois de guidage sur les deux côtés du second canal (C2) pour obturer un côté d'entrée de celui-ci, et les secondes extrémités des secondes parois de guidage sont opposées aux premières extrémités des premières parois de guidage,
dans lequel le premier module de refroidissement est destiné à entrer en contact avec une surface des modules de puissance (E) et comprend une entrée à travers laquelle le fluide de refroidissement doit être introduit à travers un passage d'écoulement d'alimentation et le second module de refroidissement est destiné à entrer en contact avec l'autre surface des modules de puissance (E) et comprend une sortie à travers laquelle le fluide de refroidissement doit s'écouler vers l'extérieur à travers un passage d'écoulement d'évacuation,
dans lequel la plaque à plots (PP) du premier module de refroidissement est destinée à entrer en contact avec une surface latérale des modules de puissance (E), la plaque à plots (PP) du second module de refroidissement est destinée à entrer en contact avec l'autre surface latérale des modules de puissance (E), et des extrémités des plaques à plots (PP) du premier module de refroidissement et du second module de refroidissement se faisant face sont reliées l'une à l'autre par une partie de liaison pour distribuer le fluide de refroidissement, et
dans lequel le premier canal (C1) d'un groupe de canaux d'un premier côté a la première partie d'obturation (B1) reliée à la seconde partie d'obturation (B2) du second canal (C2) du groupe de canaux de l'autre côté adjacent au groupe de canaux du premier côté, et le second canal (C2) du groupe de canaux du premier côté a le côté sortie relié à un côté entrée du premier canal (C1) du groupe de canaux de l'autre côté adjacent au groupe de canaux du premier côté.

2. Appareil de refroidissement selon la revendication 1,
dans lequel un angle de croisement entre la première direction et la seconde direction est de 80 degrés à 100 degrés.

3. Appareil de refroidissement selon la revendication 1,
dans lequel la première direction et la seconde direction se croisent verticalement l'une l'autre.

4. Appareil de refroidissement selon la revendication 1,
dans lequel l'entrée est disposée dans le couvercle de collecteur (M) du premier module de refroidissement, et la sortie est disposée dans le couvercle de collecteur (M) du second module de refroidissement.

5. Appareil de refroidissement selon la revendication 1,
dans lequel les plaques à plots (PP) du premier module de refroidissement et du second module de refroidissement se faisant face sont espacées les unes des autres, et la partie de liaison est disposée en un point entre les plaques à plots (PP) espacées l'une de l'autre.

6. Appareil de refroidissement selon la revendication 1,
dans lequel au moins un plot parmi la pluralité de plots (P) de la plaque à plots (PP) fait saillie depuis la plaque à plots (PP), et ledit au moins un plot a une forme dans laquelle une aire de section transversale horizontale est réduite vers l'extrémité saillante.

7. Appareil de refroidissement selon la revendication 6,
dans lequel ledit au moins un plot a une forme dans laquelle une forme de section transversale verticale de l'extrémité saillante est un triangle ou une courbe.

8. Appareil de refroidissement selon la revendication 1,
dans lequel le couvercle de collecteur (M) inclut en outre un rebord soudé, collé ou boulonné à la plaque à plots (PP).
